## Europäisches Patentamt
## European Patent Office
## Office européen des brevets

(19)

(11) Veröffentlichungsnummer : **0 057 751 B1**

(12) **EUROPÄISCHE PATENTSCHRIFT**

(45) Veröffentlichungstag der Patentschrift :
**17.08.88**

(21) Anmeldenummer : **81108370.8**

(22) Anmeldetag : **15.10.81**

(51) Int. Cl.⁴ : **H 03 H 15/02**

(54) **CTD-Transversalfilter.**

(30) Priorität : **09.02.81 DE 3104521**

(43) Veröffentlichungstag der Anmeldung :
**18.08.82 Patentblatt 82/33**

(45) Bekanntmachung des Hinweises auf die Patenterteilung : **17.08.88 Patentblatt 88/33**

(84) Benannte Vertragsstaaten :
**DE FR GB**

(56) Entgegenhaltungen :
**EP-A- 0 006 053**
**FR-A- 2 349 236**

(73) Patentinhaber : **Siemens Aktiengesellschaft Berlin und München**
**Wittelsbacherplatz 2**
**D-8000 München 2 (DE)**

(72) Erfinder : **Lüder, Rainer, Dr.-Ing.**
**Kohlstattstrasse 10**
**D-8024 Oberhaching (DE)**
Erfinder : **Haussmann, Wolfgang, Dipl.-Ing.**
**Untersbergstrasse 90**
**D-8000 München 90 (DE)**

EP 0 057 751 B1

**0 057 751**

**Beschreibung**

Die Erfindung betrifft ein CTD Transversalfilter nach dem Oberbegriff des Patentanspruches 1.

Die Übertragungscharakteristik eines allgemeinen Transversalfilters ist z-transformiert gegeben durch

$$H(z) = y(z)/x(z) = a_0 + a_i z^{-2} ... + a_n z^{-n} \text{ mit}$$

x (z) : Eingangssignal
y (z) : Ausgangssignal
$a_0 ... a_n$ : Gewichtungskoeffizienten und
$z = e^{j\omega T}$, T = Taktperiode.

Entsprechende, in CTD (Charge-Transfer-Device) -Technik hergestellte Transversalfilter sind aus C.H. Séquin, M.F. Tompsett, Charge Transfer Devices, 1975, Academic Press, S. 216-227 bekannt. Ein solches Filter kann durch einen einen Kanal aufweisenden CTD-Verzögerungsbaustein, der mehrere Anzapfungen aufweist, an denen die korrespondierenden Spannungen erfaßt, anschließend elektronisch justierbar und vorzeichenrichtig gewichtet und summiert werden, realisiert werden. Eine solche elektronische Wichtung erfordert jedoch zusätzlich zum CTD-Filter Bauelemente und kann die Filterfunktion unerwünscht beeinflussen.

Dies kann durch die Verwendung von geteilten Elektroden (« split electrodes »), deren Teillängen entsprechend der gewünschten Größe der Gewichtungskoeffizienten gewählt werden, verhindert werden, jedoch können auf diese Weise nur positive Gewichtungskoeffizienten realisiert werden. Ferner ist nach wie vor zur Summation ein Differenzverstärker o.ä. notwendig.

Aus der EP-A-0 006 053 ist ein CTD-Transversalfilter gemäß dem Oberbegriff des Patentanspruchs 1 bekannt. Um unterschiedliche Vorzeichen der Gewichtungskoeffizienten in diesem bekannten Zweitaktsystem zu realisieren, wird die Anzahl der Elektroden der parallelen Kanäle so gewählt, daß Gewichtskoeffizienten mit gleichem Vorzeichen sich um mindestens eine volle Taktperiode und solche mit ungleichem Vorzeichen sich um mindestens eine halbe Taktperiode unterscheiden. Die Vorzeichenumkehr erfolgt somit durch taktgesteuerte Zeitverzögerung der Ladungspakete.

Auf dem gleichen Prinzip der Vorzeichenumkehr beruht auch die Anordnung gemäß der FR-A-2 349 236, aus der es bekannt ist, Dioden, die aus einer p-leitenden Zone in einem n-leitenden Substrat bestehen und die die Ladungspakete erzeugen, mit einer Vorspannungsquelle zu verbinden, um deren Betrieb in Durchlaßrichtung zu vermeiden, während das Eingangssignal an der jeweils zweiten Gateelektrode liegt. Alternativ kann die Vorspannung und das Eingangssignal vertauscht werden.

Es ist Aufgabe der Erfindung, ein allgemeines CTD-Filter anzugeben, das ohne aktive Peripherie wie Verstärker u.ä. auskommt und unterschiedliche Vorzeichen der Gewichtungskoeffizienten ohne taktgesteuerte Zeitverzögerung der Ladungspakete erreicht. Diese Aufgabe wird bei einer Vorrichtung der eingangs genannten Art durch die kennzeichnenden Maßnahmen gemäß Anspruch 1 erreicht.

Auf diese Weise gelingt es auch negative Gewichtungskoeffizienten zu realisieren und ohne zusätzliche aktive Peripherie das Ausgangssignal des Filters direkt am Ausgang des CTD's abzunehmen.

Ausgestaltungen des erfindungsgemäßen CTD-Filters sind in Unteransprüchen gekennzeichnet.

Die Erfindung wird im folgenden anhand der ein Ausführungsbeispiel des erfindungsgemäßen CTD-Filters zeigenden Figur näher erläutert.

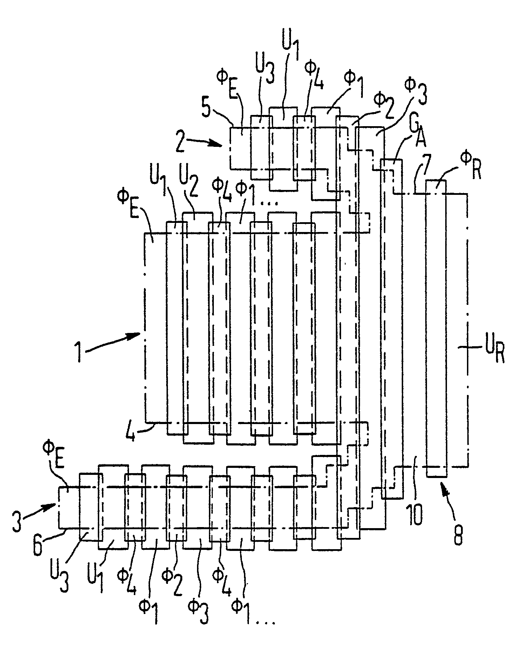

Die Figur zeigt die Ladungstransferkanäle und die Elektrodenfiguration eines als CCD (Charge-Coupled-Device) ausgeführten CTD-Filters, das die Filtercharakteristik

$$H_1(z) = K_2 + K_1 z^{-1} + K_3 z^{-2}$$

mit $K_1 > 0$ und $K_2$, $K_3 < 0$ realisiert. Beim als Ausführungsbeispiel gewählten Filter handelt es sich um eine 4-Phasen-Schaltung mit drei getrennten, aber gemeinsam angesteuerten Eingangsstufen, die nach der sogenannten « fill and spill » -Methode arbeiten.

Das Einbringen von Ladungen in die Eingangs-Potentialmulde eines CCD nach der « fill and spill » -Methode ist bekannt und in der oben erwähnten Literaturstelle « Charge Transfer Devices » auf den Seiten 48 - 50 näher beschrieben.

Die drei Eingangsstufen 1, 2, 3 des CCD-Filters weisen je einen — strichpunktiert dargestellten — Transferkanal 4, 5, 6 auf, über dem in an sich bekannter Weise verschiedene Gateelektroden angeordnet sind. Das an den Elektroden $U_1$ aller Eingangsstufen 1, 2, 3 anliegende Eingangssignal wird mittels des für alle Eingangsstufen 1, 2, 3 identischen, an den Eingangsdioden angelegten Eingangstaktes abgetastet. $U_2, U_3$ sind Hilfssignale (Gleichspannungen).

Eine Speicherzelle des 4-Phasen-CCD weist 4, von den Taktphasen $\phi_1$, $\phi_2$, $\phi_3$, $\phi_4$ beaufschlagte Elektroden auf. Die Taktfrequenzen sind mit der Abtastfrequenz identisch, während die Phasen jeweils um eine viertel Periode zueinander verschoben sind.

Die Eingangsstufe 2 weist eine Speicherzelle, die Eingangsstufe 1 zwei Speicherzellen und die Eingangsstufe 3 drei Speicherzellen auf. Da die drei Kanäle 4, 5, 6 der Eingangsstufen 1, 2, 3 zu einem

2

gemeinsamen Kanal 7 zusammengeführt werden, erreicht das Eingangssignal den gemeinsamen Kanal 7 über die Eingangsstufe 2 um eine Taktperiode früher als über die Eingangsstufe 1, während das Eingangssignal über die Eingangsstufe 3 den gemeinsamen Kanal 7 um eine Taktperiode später als über die Eingangsstufe 1 erreicht. Im gemeinsamen Kanal 7 werden die Signal der Eingangsstufen 1, 2, 3 summiert, so daß das so entstandene Filter die Form

$$H_1(z) = K_2 + K_1 z^{-1} + K_3 z^{-2}$$

aufweist.

Die Wahl der Koeffizienten $K_1$, $K_2$ und $K_3$ bestimmt die Impulsantwort des Filters, wobei Absolutbetrag und Vorzeichen der Koeffizienten durch die Ausgestaltung der zu den betreffenden Koeffizienten gehörenden Eingangsstufen bestimmt wird. Das Verhältnis des Absolutbetrages der Koeffizienten wird durch die Flächenverhältnisse der Elektroden, unter denen die der Eingangsspannung proportionale Ladung gebildet wird, festgelegt. Das heißt, die wirksame Fläche der Eingangselektroden wird so gewählt, daß das Verhältnis dieser Flächen dem gewünschten Verhältnis der Koeffizienten entspricht.

Um im übrigen gleiche Eingangskennlinien zu gewährleisten, sollte die räumliche Anordnung und die technologische Herstellung der Eingangselektroden, bzw. der Eingangsstufen, insbesondere Zusammensetzung und Dicke des unter den Elektroden liegenden Dünnoxids und die Grunddotierung des Kanals, gleich sein.

Negative Vorzeichen der Koeffizienten $K_1$, $K_2$, $K_3$ werden dadurch realisiert, daß Eingangsstufen, die einen negativen Koeffizienten realisieren, gegenüber einen positiven Koeffizienten realisierenden Eingangsstufe invertierend ausgeführt sind. Dies ist im Ausführungsbeispiel bei den Eingangsstufen 2 und 3 der Fall. Steuert das Eingangssignal $U_1$ die erste Elektrode der Eingangsstufe an, so arbeitet die Schaltung nicht invertierend. Wird $U_1$ dagegen auf die zweite Elektrode gelegt, so ergibt sich ein invertierendes Verhalten. Im in der Figur gezeigten Beispiel arbeiten demnach die äußeren Eingangsstufen 2, 3 invertieren, während die mittlere Eingangsstufe 1 nicht invertierend arbeitet, die Koeffizienten $K_2$ und $K_3$ sind also negativ, der Koeffizient $K_1$ positiv.

Die gewünschte absolute Größe der Gewichtungskoeffizienten kann durch Verstärkung des Ausgangssignals gewonnen werden.

Die Gestaltung der Ausgangsstufe 8, in der das im gemeinsamen Kanal 7 summierte Ladungspaket in eine proportionale Spannung gewandelt wird, ist zum Beispiel aus der obengenannten Literaturstelle « Charge Transfer Devices », bekannt. In der Figur sind mit $G_A$ das Ausgangsgate, mit $\phi_R$ der Rücksetztakt und mit $U_R$ die Rücksetzspannung bezeichnet. Das Ausgangssignal wird über die Verbindung 10 zu einer Ausgangsschaltung geführt.

An Stelle der in der Figur gezeigten Anordnung, bei der die Ausgangsstufe 8 direkt an die Eingangsstufen 1, 2, 3 anschließt, ist es auch möglich, zwischen Eingangsstufen 1, 2, 3 und Ausgangsstufe 8 ein kurzes gemeinsames Kanalstück, mit dem die Grundlaufzeit der Anordnung eingestellt werden kann, vorzusehen.

Das gezeigte Ausführungsbeispiel arbeitet mit einem 4-Phasen-Takt, es ist aber ebensogut möglich, das erfindungsgemäße CTD-Filter z. B. mit einem 2 oder einem 3-Phasen-Takt arbeitend auszuführen.

Bei hohen Taktfrequenzen empfiehlt es sich, die Kanäle 4, 5, 6 zwischen den Eingangsstufen 1, 2, 3 und der Zusammenführung zum gemeinsamen Kanal 7 so auszuführen, daß die zurückzulegende Strecke der Ladungsträger von Elektrode zu Elektrode möglichst wenig erhöht wird. Dies kann vorteilhafterweise — wie in der Figur gezeigt — dadurch geschehen, daß die Kanäle 5 und 6 der Eingangsstufen 2 und 3 zum mittleren Kanal 4 hinzeigend treppenförmig ausgeführt sind.

Mit dem erfindungsgemäßen CTD-Filter gelingt es, ein allgemeines nicht rekursives Filter zu erhalten, bei dem die Vorzeichen der Gewichtungskoeffizienten beliebig sind und auf eine aktive Peripherie vollständig verzichtet werden kann, daß heißt, Ausgangssignal des Filters und Ausgangssignal des CTD sind identisch.

Läßt sich die gewünschte Filtercharakteristik H(z) durch Faktorenzerlegung so darstellen, daß

$$H(z) = H_1(z) \cdot H_2(z) \ldots . H_n(z)$$

gilt, so kann das gewünschte Filter durch Reihenschaltung einzelner, die Funktionen $H_1(z)$ bis $H_n(z)$ realisierender CTD-Filter geschaffen werden. Vorteilhafterweise wird das Teilfilter, bei dem negative Gewichtungskoeffizienten benötigt werden, in erfindungsgemäßer Weise ausgeführt und an die vom Eingangssignal beaufschlagte Stelle der Reihenschaltung gelegt.

## Patentansprüche

1. CTD-Transversalfilter, bei dem zeitverzögerte Formen eines gegebenen Eingangssignals zum Erzeugen der Filtercharakteristik gewichtet und anschließend summiert werden, wobei zur Bildung jedes zum Erzielen der gewünschten Filtercharakteristik benötigten Gewichtungskoeffizienten eine getrennte Eingangsstufe vorgesehen ist, in der das mit einer für alle Eingangsstufen gleichen Abtastfrequenz abgetastete und in ein spannungsproportionales Ladungspaket umgewandelte Eingangssignal zeitverzögert wird, wobei die Gewichtungskoeffizienten sowohl ein negatives als auch ein positives Vorzeichen aufweisen können und die zur Bildung von negativen Gewichtungskoeffizienten vorgesehenen Eingangsstufen im Vergleich zu den zur Bildung von positiven Gewichtungskoeffizienten vorgesehenen Eingangsstufen invertierend ausgeführt sind, wobei die Flächen der Gate-Elektroden der Eingangsstufen, unter denen die der Eingangsspannung proportionalen Ladungspakete gebildet werden, dem Verhältnis der Absolutgrößen der benötigten Gewichtungskoeffizienten entspechen und wobei die Eingangsstufen zu einer gemeinsamen Ausgangsstufe zusammengeführt sind, dadurch gekennzeichnet, daß bei einer invertierend ausgeführten Eingangsstufe (2,3) die erste Gate-Elektrode ($U_3$) mit einer Hilfsspannung und die zweite Gate-Elektrode ($U_1$) mit dem Eingangssignal und bei einer nicht invertierend ausgeführten Eingangsstufe (1) die erste Gate-Elektrode ($U_1$) mit dem Eingangssignal und die zweite Gate-Elektrode ($U_2$) mit einer Hilfsspannung beaufschlagt sind.

2. CTD-Transversalfilter nach Anspruch 1, dadurch gekennzeichnet, daß die Kanäle (4, 5, 6) zwischen den Eingangsstufen (1, 2, 3) und der Zusammenführung zum gemeinsamen Kanal (7), der der Ausgangsstufe (8) zugeordnet ist, so ausgeführt sind, daß die zurückzulegende Strecke der Ladungsträger von Elektrode zu Elektrode der Eingangsstufen (1, 2, 3) und der Ausgangsstufe (8) möglichst wenig erhöht wird.

3. CTD-Transversalfilter nach einem der Ansprüche 1 oder 2, dadurck gekennzeichnet, daß das unter den Gateelektrodes ($U_1,U_2$), unter denen die der Eingangsspannung proportionalen Ladungspakete gebildet werden, befindliche Gateoxid in Zusammensetzung und Dicke in den einzelnen Eingangsstufen (1, 2, 3) identisch ist.

4. CTD-Transversalfilter nach einem der Ansprüche 1 bis 3, dadurch gekennzeichnet, daß die einzelnen Eingangsstufen (1, 2, 3) in technologisch gleicher Weise hergestellt sind.

### Claims

1. A CTD transversal filter in which, for the production of the filter characteristic, time-delayed forms of a given input signal are weighted and then added, where, for the formation of each weighting coefficient which is required to produce the desired filter characteristic, a separate input stage is provided in which the input signal, which has been sampled with a sampling frequency which is identical for all the input stages, and has been converted into a voltage-proportional charge packet, is time-delayed ; where the weighting coefficients cas possess both a negative and a positive sign ; and where the input stages which serve to form negative weighting coefficients are designed with inverting functions in comparison to the input stages which are provided to form positive weighting coefficients ; where the surface areas of the gate electrodes of the input stages under which the charge packets proportional to the input voltage are formed, correspond to the ratio of the absolute values of the required weighting coefficients ; and where the input stages are combined to form a common output stage, characterised in that, in the case of an input stage (2,3) which is designed with an inverting function, the first gate electrode ($U_3$) is supplied with an auxiliary voltage, and the second gate electrode ($U_1$) is supplied with the input signal, and, in the case of an input stage (1) which is designed with a non-inverting function, the first gate electrode ($U_1$) is supplied with the input signal, and the second gate electrode ($U_2$) is supplied with an auxiliary voltage.

2. A CTD transversal filter as claimed in Claim 1, characterised in that the channels (4,5,6) between the input stages (1,2,3) and the combined common channel (7) which is assigned to the output stage (8) are designed to be such that the path to be travelled by the charge carriers from electrode to electrode of the input stages (1,2,3) and the ouput stage (8) is increased to the smallest extent possible.

3. A CTD transversal filter as claimed in one of Claims 1 or 2, characterised in that the gate oxide layer which is arranged beneath the gate electrodes ($U_1,U_2$), under which are formed the charge packets which are proportional to the input voltage, is identical in respect of its composition and thickness in the individual input stages (1,2,3).

4. A CTD transversal filter as claimed in one of Claims 1 to 3, characterised in that the individual input stages (1,2,3) are produced in accordance with the same technology.

### Revendications

1. Filtre transversal CTD ou à transfert de charges, dans lequel des formes retardées dans le temps d'un signal d'entrée donné sont pondérées et sommées ensuite pour élaborer la caractéristique de filtrage, avec prévision, pour la formation de chaque coefficient de pondération nécessaire à l'obtention de la caractéristique de filtrage désirée, d'un étage d'entrée séparé dans lequel le signal d'entrée, échantillonné avec une fréquence d'échantillonnage égale pour tous les étages d'entrée et transformé en un paquet de charge proportionnel à la tension d'entrée, est retardé dans le temps, les coefficients de pondération pouvant présenter aussi bien un signe négatif qu'un signe positif et les étages d'entrée prévus pour la formation de coefficients de pondération négatifs étant réalisés avec inversion

**0 057 751**

comparativement aux étages d'entrée prévus pour la formation de coefficients de pondération positifs, les aires des électrodes de grille des étages d'entrée, sous lesquelles sont formés les paquets de charge proportionnels à la tension d'entrée, correspondant au rapport des grandeurs absolues des coefficients de pondération nécessaires et les étages d'entrée étant réunis en un étage de sortie commun, caractérisé en ce que, dans un étage d'entrée (2, 3) réalisé avec inversion, la première électrode de grille ($U_3$) est alimentée avec une tension auxiliaire et la seconde électrode de grille ($U_1$) est alimentée avec le signal d'entrée, et dans un étage d'entrée (1) réalisé sans inversion, la première électrode de grille ($U_1$) est alimentée avec le signal d'entrée et la seconde électrode de grille ($U_2$) est alimentée avec une tension auxiliaire.

2. Filtre selon la revendication 1, caractérisé en ce que les canaux (4, 5, 6) entre les étages d'entrée (1, 2, 3) et la réunion en canal commun (7), lequel est coordonné à l'étage de sortie (8), sont réalisés de manière que le parcours à effectuer par les porteurs de charge d'une électrode à l'autre des étages d'entrée (1, 2, 3) et de l'étage de sortie (8) soit augmenté aussi peu que possible.

3. Filtre selon la revendication 1 ou 2, caractérisé en ce que l'oxyde de grille se trouvant sous les électrodes de grille ($U_1, U_2$) sous lesquelles sont formés les paquets de charge proportionnels à la tension d'entrée, possède la même composition et la même épaisseur dans les différents étages d'entrée (1, 2, 3).

4. Filtre selon une des revendications 1 à 3, caractérisé en ce que les différents étages d'entrée (1, 2, 3) sont réalisés technologiquement de la même manière.

5